# EUROPEAN PATENT APPLICATION

(11) **EP 4 739 028 A1**
(43) Date of publication of application: **06.05.2026**
(21) Application number: 25194609.1
(22) Date of filing: 07.08.2025
(51) Int. Cl.: H10D 30/01, H10D 30/67, H10D 86/40

(54) **THIN FILM TRANSISTOR, METHOD FOR MANUFACTURING THE SAME, AND DISPLAY APPARATUS COMPRISING THE SAME**

(30) Priority: 01.11.2024 KR 20240153511
(71) Applicant: LG Display Co., Ltd., Seoul, 07336 (KR)
(72) Inventor: CHOI, Sungju, 10845 Paju-si (KR); KO, Younghyun, 10845 Paju-si (KR); JANG, Jaeman, 10845 Paju-si (KR); RYU, Jihee, 10845 Paju-si (KR)
(74) Representative: Ter Meer Steinmeister & Partner

(57) **Abstract**

The present disclosure provides a thin film transistor comprising a gate electrode, an active layer, a source electrode, and a drain electrode, wherein the active layer includes a first channel part overlapping the source electrode, a second channel part overlapping the drain electrode, and a connection part connecting the first channel part and the second channel part, and the connection part is a conductorized region. Additionally, a manufacturing method of the thin film transistor and a display apparatus including the thin film transistor mentioned above are disclosed.

## Description

This application claims the benefit of priority of the Republic of Korea Patent Application No. 10-2024-0153511 filed on November 1, 2024.

### BACKGROUND

### Field of Technology

The present disclosure relates to a thin film transistor, a method for manufacturing the same, and a display apparatus including the thin film transistor.

### Discussion of the Related Art

Since thin film transistors may be manufactured on glass or plastic substrates, they are widely used as switching elements or driving elements in display apparatuses such as liquid crystal display apparatuses or organic light emitting devices.

Thin film transistors may be classified into amorphous silicon thin film transistors in which amorphous silicon is used as the active layer, polycrystalline silicon thin film transistors in which polycrystalline silicon is used as the active layer, and oxide semiconductor thin film transistors in which oxide semiconductor is used as the active layer, depending on the material constituting the active layer.

Among these, the oxide semiconductor thin film transistors that have high mobility and a large resistance variation depending on the oxygen content have the advantage of being able to easily obtain desired property. Since the oxide constituting the active layer may be formed at a relatively low temperature during the manufacturing process of oxide semiconductor thin film transistors, the manufacturing cost is low. Additionally, since oxide semiconductors are transparent due to the nature of oxides, they are also advantageous in implementing transparent display.

High resolution displays include a large number of thin film transistors. In order to arrange a large number of thin film transistors in a given area, the size of the thin film transistors must be reduced. However, when the size of the thin film transistor is reduced, the channel length also becomes shorter, which may deteriorate the operating stability of the thin film transistor or cause a characteristic deviation between multiple thin film transistors, which may deteriorate the display quality of the display apparatus.

In order for a thin film transistor to operate stably, the channel must have an effective channel length greater than a certain value. In the case of a thin film transistor with a coplanar structure, control over the conductorized region is important to secure the channel length.

In a thin film transistor, a phenomenon in which a conductorized region penetrates into a channel may occur. If the length of the conductorized region penetrated into the channel is not constant, the effective channel length of the thin film transistor becomes not constant, and characteristic deviation may occur between the thin film transistors. In particular, if the effective channel length is not constant in a short channel thin film transistor with a short channel length, the characteristic deviation between the thin film transistors becomes significant, making it difficult to manufacture a large area panel.

Therefore, in order to manufacture a high resolution display apparatus with excellent display quality, it is necessary to increase the integration density of thin film transistors by shortening the channel length of the thin film transistors and at the same time secure characteristic uniformity between the thin film transistors.

### SUMMARY

It is an object of the present invention to provide a thin film transistor, a display apparatus having the same and a manufacturing method of a thin film transistor, wherein the thin film transistor has a short channel.

It is an object of the present invention to provide a thin film transistor having a short channel with a short length while having excellent uniformity, and a display apparatus having the same and a manufacturing method of manufacturing the same.

It is a further object of the present invention to overcome one or more of the problems in the prior art, as discussed above.

At least one of these objects is solved by the features of the independent claims.

The present disclosure provides a technology that may easily form a short channel by using a source electrode and a drain electrode as masks in the conductorization process.

The present disclosure provides a technology of using a source electrode and a drain electrode as masks in the conductorization process so that a channel part may be defined by the source electrode and the drain electrode. In addition, The present disclosure provides a technology that allows a channel part to be defined by self-alignment as the channel part is defined by the source electrode and the drain electrode..

The present disclosure provides a manufacturing method of a thin film transistor in which a source electrode and a drain electrode are used as masks for a conductorization process.

In one aspect of the present disclosure, a thin film transistor comprises: a gate electrode; an active layer that is spaced apart from the gate electrode and at least partially overlapping the gate electrode; an interlayer insulating layer on the active layer; a source electrode on the interlayer insulating layer, the source electrode connected to the active layer; and a drain electrode on the interlayer insulating layer and spaced apart from the source electrode, the drain electrode connected to the active layer, wherein the active layer includes: a first channel part that overlaps the source electrode and the gate electrode, the first channel part between the source electrode and the gate electrode; a second channel part that overlaps the drain electrode and the gate electrode, the second channel part between the drain electrode and the gate electrode; and a connection part between the first channel part and the channel second part, the connection part connecting the first channel part and the second channel part. The connection part may be a conductorized region.

In one aspect of the present disclosure, a thin film transistor comprises: a gate electrode; an active layer that is spaced apart from the gate electrode and/or at least partially overlapping the gate electrode; and a source electrode connected to the active layer, wherein the active layer includes: a channel part that overlaps the source electrode and the gate electrode; a contact part contacting the source electrode; and a connection part that is non-overlapping with the source electrode. The channel part may be between the connection part and the contact part, and/or the connection part may be a conductorized region.

In one aspect of the present disclosure, a thin film transistor comprises: a gate electrode; an active layer at least partially overlapping the gate electrode; a source electrode on/over the active layer; and a drain electrode on/over the active layer, wherein the active layer includes a first channel part between the source electrode and the gate electrode; a second channel part between the drain electrode and the gate electrode; and a connection part connecting the first channel part and the second channel part. The connection part may be a conductorized and/or doped region.

In one aspect of the present disclosure, a thin film transistor comprises: a gate electrode; an active layer at least partially overlapping the gate electrode; a source electrode on/over the active layer; and a drain electrode, wherein the active layer includes a first channel part between the source electrode and the gate electrode; and a connection part connected to the first channel part and/or exposed by the source electrode. The connection part may be a conductorized and/or doped region.

In one aspect of the present disclosure, a thin film transistor comprises: a gate electrode; a gate insulating layer on the gate electrode; an active layer on the gate insulating layer, the active layer including a connection part having a first end and a second end that is opposite the first end, a first channel part that is in contact with the first end of the connection part, and a second channel part that is in contact with the second end of the connection part; an interlayer insulating layer on the active layer; and a source electrode and a drain electrode on the interlayer insulating layer and spaced apart from each other, the source electrode and the drain electrode connected to the active layer.

In one aspect of the present disclosure, a manufacturing method of a thin film transistor comprises: forming a gate electrode on a substrate; forming an active layer on the gate electrode, the active layer spaced apart from the gate electrode and/or at least partially overlapping the gate electrode; forming an interlayer insulating layer on the active layer, the interlayer insulating layer formed with a contact hole; forming a source electrode and a drain electrode on the interlayer insulating layer, and selectively conductorizing the active layer using the source electrode and the drain electrode as masks. The manufacturing method may be configured to manufacture a thin film transistor according to any one of the herein described aspects or embodiments.

In one aspect of the present disclosure, a manufacturing method of a thin film transistor comprises: forming a gate electrode on a substrate; forming an active layer on the gate electrode, the active layer at least partially overlapping the gate electrode; forming a source electrode on the active layer; and selectively conductorizing a region of the active layer using the source electrode (161) as mask. The conductorized region of the active layer may be a connection part. The method may comprise further forming a drain electrode on the active layer, wherein in the selectively conductorizing, the source electrode and the drain electrode are used as masks.

In one aspect of the present disclosure, a display apparatus comprises: a substrate; a gate electrode on the substrate; a gate insulating layer on the gate electrode; an active layer on the gate insulating layer, the active layer including a connection part having a first end and a second end that is opposite the first end, a first channel part that is in contact with the first end of the connection part, and a second channel part that is in contact with the second end of the connection part; an interlayer insulating layer on the active layer; a source electrode and a drain electrode on the interlayer insulating layer and spaced apart from each other, the source electrode and the drain electrode connected to the active layer; and a light-emitting element that emits light, the light-emitting element connected to one of the source electrode or the drain electrode. The connection part of the active layer may be non-overlapping with the source electrode and/or the drain electrode. The connection part may be a conductorized region.

In one aspect of the present disclosure, a display apparatus comprises a thin film transistor according to any one of the herein described aspects or embodiments.

The thin film transistor, the manufacturing method, and/or the display apparatus according to any one of these aspects may include one or more of the following features:

The thin film transistor may have a coplanar structure. The thin film transistor may have a bottom-gate structure. The thin film transistor may be an oxide semiconductor thin film transistor.

The active layer may be spaced apart from the gate electrode and/or may be at least partially overlapping the gate electrode.

The thin film transistor may comprise an interlayer insulating layer on the active layer. The source electrode and/or the drain electrode may be disposed on the interlayer insulating layer. The interlayer insulating layer may be between the source and drain electrodes and the active layer.

The thin film transistor may comprise an gate insulating layer on the gate electrode and/or between the gate electrode and the active layer.

The source electrode may be connected to the active layer, e.g. through a contact hole in the interlayer insulating layer. The drain electrode may be connected to the active layer, e.g. through a contact hole in the interlayer insulating layer.

The active layer may include a (first) channel part that overlaps the source electrode and/or that is disposed between the source electrode and the gate electrode. The (first) channel part that overlaps the source electrode may also overlap the gate electrode. The (first) channel part that overlaps the source electrode may be arranged or disposed between the source electrode and the gate electrode. The active layer may include a (second) channel part that overlaps the drain electrode and/or that is disposed between the drain electrode and the gate electrode. The (second) channel part that overlaps the drain electrode may also overlap the gate electrode. The (second) channel part that overlaps the drain electrode may be arranged or disposed between the drain electrode and the gate electrode.

The active layer may include a connection part connecting the first channel part and the second channel part and/or which is between the first channel part and the second channel part. The connection part may be a conductorized region of the active area and/or may be doped.

The active layer may be or include an oxide semiconductor layer.

The connection part may be doped with a dopant. The (first and/or second) channel part may be doped with a dopant, i.e. with a same dopant or different dopants. A dopant concentration of the connection part may be higher than a dopant concentration of the channel part. A dopant concentration of the connection part may be higher than a dopant concentration of the first channel part and/or a dopant concentration of the second channel part. A dopant of the connection part may be the same as a dopant of the (first and/or second) channel part.

The connection part may be non-overlapping with the source electrode and/or the drain electrode. That is, the connection part may be exposed by the source electrode and/or the drain electrode.

The active layer may include a first contact part contacting the source electrode, and/or a second contact part contacting the drain electrode.

The first channel part may be between the connection part and the first contact part. The second channel part may be between the connection part and the second contact part.

The connection part may overlap the gate electrode.

At least a portion of the connection part may be non-overlapping with the gate electrode. That is, at least a portion of the connection part may be exposed by the gate electrode.

The gate electrode may comprise a first gate electrode, the first gate electrode overlapping the first channel part and the source electrode, and/or a second gate electrode, the second gate electrode overlapping the second channel part and the drain electrode.

At least a portion of the connection part may be non-overlapping with the first gate electrode and/or the second gate electrode. That is, at least a portion of the connection part may be exposed by the first gate electrode and/or the second gate electrode.

The interlayer insulating layer may be on the connection part.

At least a portion of the connection part may be non-overlapping with the interlayer insulating layer. That is, at least a portion of the connection part may be exposed by the interlayer insulating layer.

The display apparatus and/or the thin film transistor may comprise a capping layer in contact with the connection part. The capping layer may have a reducing property, e.g. that reduces a property of the connection part. The capping layer may have a reducing property and/or may be configured to reduce the connection part. The capping layer may include at least one of titanium, molybdenum, aluminum, indium, and zinc.

The display apparatus and/or the thin film transistor may comprise a passivation layer on the source electrode and the drain electrode.

The thin film transistor may comprise a gate insulating layer over the gate electrode. The gate insulating layer may be disposed between the gate electrode and the active layer. The gate insulating layer may cover a top surface and/or a side surface of the gate electrode. The active layer and/or the connection part may be disposed on the gate insulating layer.

A first end of the connection part that is connected to the (first) channel part may have a first height that is higher than a second end of the connection part that is opposite to the first end. A first end of the connection part that is connected to the (first) channel part may have a first height that is higher than a second end of the connection part that is disposed on a side surface of the gate insulating layer. In other words, the connection part may include a step portion or side portion corresponding to a step portion or side portion in the gate insulating layer. The step portion or side portion in the gate insulating layer may correspond to a portion of the gate insulating layer covering the side surface of the gate electrode.

The active layer may comprise a first oxide semiconductor layer. The active layer may further comprise a second oxide semiconductor layer on the first oxide semiconductor layer. The conductorized region of the active layer may be a connection part.

In the manufacturing method, the step of selectively conductorizing the active layer may comprise conductorizing a region of the active layer that is non-overlapping the source electrode and the drain electrode. The conductorized region of the active layer may be a connection part.

A region of the active layer that is overlapping the source electrode may be not conductorized during the selective conductorizing and/or may be a first channel part. A region of the active layer overlapping the drain electrode may be not conductorized during the selective conductorizing and/or may be a second channel part. The conductorized region may be connecting the first channel part and the second channel part, and/or may be denoted as connection part.

In the manufacturing method, the step of selectively conductorizing the active layer may comprise a dopant doping of the active layer.

### BRIEF DESCRIPTION OF THE DRAWINGS

These and other objects, features and other advantages of the present disclosure will be more clearly understood from the following detailed description taken in conjunction with the accompanying drawings, in which:
FIG. 1 is a plan view of a thin film transistor according to one embodiment of the present disclosure.
FIG. 2 is a cross-sectional view taken along line I-I' of FIG.1 according to one embodiment of the present disclosure.
FIG. 3 is a circuit diagram of a thin film transistor according to one embodiment of the present disclosure.
FIG. 4 is a plan view of a thin film transistor according to an embodiment of the present disclosure.
FIG.5 is a cross-sectional view taken along line II-II' of FIG. 4 according to one embodiment of the present disclosure.
FIG. 6 is a cross-sectional view of a thin film transistor according to an embodiment of the present disclosure.
FIG. 7 is a cross-sectional view of a thin film transistor according to an embodiment of the present disclosure.
FIG. 8 is a cross-sectional view of a thin film transistor according to an embodiment of the present disclosure.
FIG. 9 is a cross-sectional view of a thin film transistor according to an embodiment of the present disclosure.
FIGs. 10A to 10E are schematic cross-sectional views illustrating a method for manufacturing a thin film transistor according to one embodiment of the present disclosure.
FIG. 11 is a schematic diagram of a display apparatus according to an embodiment of the present disclosure.
FIG. 12 is a circuit diagram for one pixel of FIG. 11 according to one embodiment of the present disclosure.
FIG.13 is a plan view of the pixels of FIG. 12 according to one embodiment of the present disclosure.
FIG. 14 is a cross-sectional view taken along line III-III' of FIG. 13 according to one embodiment of the present disclosure.

### DETAILED DESCRIPTION

The advantages and features of the present disclosure, and the methods for achieving them, will become clear with reference to the embodiments described in detail below together with the accompanying drawings. However, the present disclosure is not limited to the embodiments disclosed below, but may be implemented in various different forms. These embodiments are intended to make the disclosure of the present disclosure complete, and to enable those skilled in the art to easily understand the invention.

The shapes, sizes, ratios, angles, numbers, or the like. disclosed in the drawings for explaining embodiments of the present disclosure are exemplary, and the present disclosure is not limited to the matters illustrated in the drawings. The same components may be referred to by the same reference numerals throughout the specification. Additionally, in explaining the present disclosure, if it is determined that a detailed description of a related known technology may unnecessarily obscure the gist of the present disclosure, the detailed description is omitted.

In this specification, when the words "includes," "has," "comprising" or the like are used, other parts may be added unless the expression "only" is used. When a component is expressed in the singular, the plural is included unless otherwise explicitly stated.

When interpreting a component, it is interpreted as including the error range even if there is no separate explicit description.

For example, when the positional relationship between two parts is described as "on ~", "above ~", "below ~", "next to ~", or the like., one or more other parts may be located between the two parts, unless the expression "right" or "directly" is used.

The spatially relative terms "below," "beneath," "lower," "above," "upper," and the like may be used to easily describe the relationship of one element or component to another element or component, as illustrated in the drawings. The spatially relative terms should be understood to include different orientations of the elements during use or operation in addition to the orientations depicted in the drawings. For example, if an element illustrated in the drawings is flipped over, an element described as "below" or "beneath" another element may end up being placed "above" the other element. Thus, the exemplary term "below" may include both the above and below directions. Likewise, the exemplary term "above" or "above" may include both the above and below directions.

When describing a temporal relationship, for example, when describing a temporal relationship such as "after", "following", "next to", "before", or the like., it can also include cases where there is no continuity, as long as the expression "right away" or "directly" is not used.

Although the terms first, second, or the like. are used to describe various components, these components are not limited by these terms. These terms are only used to distinguish one component from another. Accordingly, a first component referred to below may also be a second component within the technical concept of the present disclosure.

At least one term should be understood to include all combinations that may be presented from one or more of the associated items. For example, the meaning of "at least one of the first, second, and third items" can mean not only each of the first, second, or third items, but also all combinations of items that may be presented from two or more of the first, second, and third items.

The individual features of the various embodiments of the present disclosure may be partially or wholly combined or combined with each other, and may be technically linked and driven in various ways, and each embodiment may be implemented independently of each other or may be implemented together in a related relationship.

When adding reference numerals to components of each drawing describing embodiments of the present disclosure, identical components may have the same numerals as much as possible even if they are shown in different drawings.

In the embodiments of the present disclosure, the source electrode and the drain electrode are distinguished only for convenience of explanation, and the source electrode and the drain electrode may be interchanged. Additionally, the source electrode of one embodiment may become the drain electrode in another embodiment, and the drain electrode of one embodiment may become the source electrode in another embodiment.

In some embodiments of the present disclosure, for convenience of explanation, the source connection part and the source electrode are distinguished, and the drain connection part and the drain electrode are distinguished, but the embodiments of the present disclosure are not limited thereto. The source connection part may be the source electrode, and the drain connection part may be the drain electrode. Additionally, the source connection part may be the drain electrode, and the drain connection part may be the source electrode.

It is noted that embodiments of the present disclosure may be combined with each other.

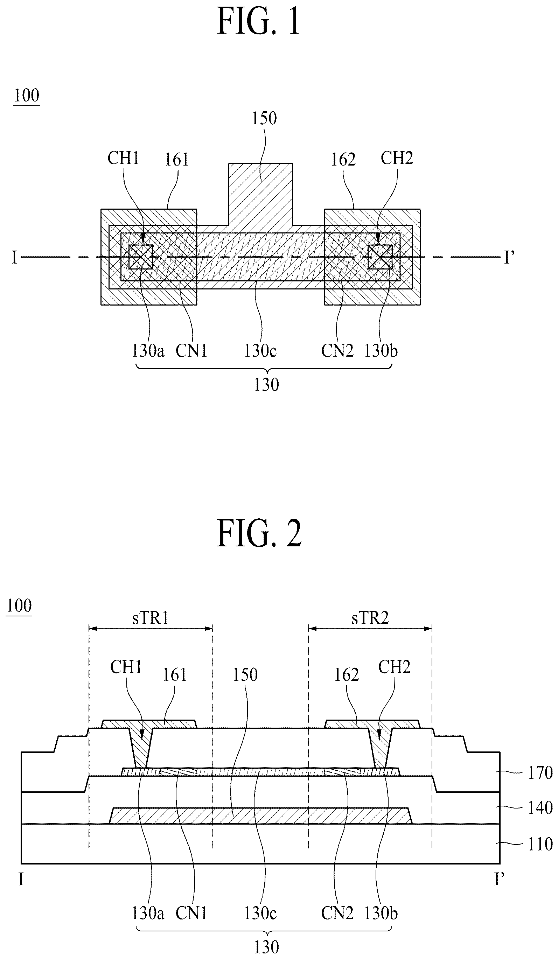

FIG. 1 is a plan view of a thin film transistor 100 according to one embodiment of the present disclosure, and FIG. 2 is a cross-sectional view taken along line I-I' of FIG. 1 according to one embodiment of the present disclosure.

Referring to FIG. 1 and FIG. 2, a thin film transistor 100 according to one embodiment of the present disclosure includes a gate electrode 150, an active layer 130, a source electrode 161, and a drain electrode 162. The active layer 130 includes a first channel part CN1, a second channel part CN2, and a connection part 130c.

Referring to FIG. 2, a thin film transistor 100 may be disposed on a substrate 110.

The substrate 110 supports the components of the thin film transistor 100. The substrate 110 may be any structure that supports the thin film transistor 100, without limitation.

A glass substrate or a polymer resin substrate may be used as the substrate 110. A plastic substrate is a polymer resin substrate. The plastic substrate may include at least one of polyimide (PI), polycarbonate (PC), polyethylene (PE), polyester, polyethylene terephthalate (PET), and polystyrene (PS) having flexible property. When a plastic is used as the substrate 110, considering that a high temperature deposition process is performed on the substrate 110, a heat-resistant plastic that may withstand high temperatures may be used.

The gate electrode 150 is disposed on the substrate 110.

According to one embodiment of the present disclosure, a buffer layer may be disposed on a substrate 110, and a gate electrode 150 may be disposed on the buffer layer.

The gate electrode 150 may include at least one of an aluminum based metal such as aluminum (Al) or an aluminum alloy, a silver based metal such as silver (Ag) or a silver alloy, a copper based metal such as copper (Cu) or a copper alloy, a molybdenum based metal such as molybdenum (Mo) or a molybdenum alloy, chromium (Cr), tantalum (Ta), neodymium (Nd), and titanium (Ti). The gate electrode 150 may also have a multilayer structure including at least two conductive layers having different physical properties.

A gate insulating layer 140 is disposed on the gate electrode 150.

According to one embodiment of the present disclosure, the gate insulating layer 140 may be disposed to cover the entire upper surface of the gate electrode 150. Referring to FIG. 2, the gate insulating layer 140 may be disposed to cover the entire upper surface of the substrate 110.

The gate insulating layer 140 may be made of at least one insulating material. The gate insulating layer 140 may include, for example, at least one of silicon oxide (SiOx), silicon nitride (SiNx), and aluminum oxide (AlOx).

The gate insulating layer 140 may have a single layer structure or a multilayer structure.

The active layer 130 is disposed on the gate insulating layer 140.

The active layer 130 is spaced apart from the gate electrode 150 in the vertical direction with respect to the substrate 110 and overlaps at least partially with the gate electrode 150. In one embodiment, a width of the active layer 130 is less than a width of the gate electrode 150 and the active layer 130 is completely overlapped by the gate electrode 150.

According to one embodiment of the present disclosure, the active layer 130 may include an oxide semiconductor material. According to one embodiment of the present disclosure, the active layer 130 may be, for example, an oxide semiconductor layer made of an oxide semiconductor material.

The active layer 130 may include at least one of oxide semiconductor materials, for example, IGZO (InGaZnO) based, IGO (InGaO) based, IGZTO (InGaZnSnO) based, GZTO (GaZnSnO) based, GZO (GaZnO) based, GO (GaO) based, TO (SnO) based, ITO (InSnO) based, ITZO (InSnZnO) based, IZO (InZnO) based, ZO (ZnO) based, InO (InO) based, ZnO based, and FIZO (FeInZnO) based.

The active layer 130 may have a single layer structure or may have a multilayer structure including two or more oxide semiconductor layers. The active layer 130 may include a channel part CN1 (e.g., a first channel part), a channel part CN2 (e.g., a second channel part), and a connection part 130c. The specific configuration of the active layer 130 will be described later.

An interlayer insulating layer 170 may be disposed on the active layer 130.

The interlayer insulating layer 170 is an insulating layer made of an insulating material. The interlayer insulating layer 170 may have a single layer structure or a multilayer structure. The interlayer insulating layer 170 may be made of an organic material or an inorganic material. Additionally, the interlayer insulating layer 170 may be made of a laminate of an organic layer and an inorganic layer.

A source electrode 161 and a drain electrode 162 are disposed on an interlayer insulating layer 170. Thus, the source electrode 161 and the drain electrode 162 are on a same plane. The source electrode 161 is connected to the active layer 130. Additionally, the drain electrode 162 is spaced apart from the source electrode 161 in the horizontal direction and is connected to the active layer 130. The source electrode 161 and the drain electrode 162 may be connected to the active layer 130 through contact holes CH1, CH2 penetrating the interlayer insulating layer 170, respectively.

The source electrode 161 and the drain electrode 162 may each include at least one of molybdenum (Mo), aluminum (Al), chromium (Cr), gold (Au), titanium (Ti), nickel (Ni), neodymium (Nd), copper (Cu), and alloys thereof. The source electrode 161 and the drain electrode 162 may each be formed of a single layer made of a metal or an alloy of metals or may be formed of two or more multilayers.

Hereinafter, the active layer 130 is described in more detail.

According to one embodiment of the present disclosure, the active layer 130 includes a first channel part CN1, a second channel part CN2, and a connection part 130c.

The first channel part CN1 overlaps the gate electrode 150 and the source electrode 161. The first channel part CN1 is disposed between the gate electrode 150 and the source electrode 161. The second channel part CN2 overlaps the gate electrode 150 and the drain electrode 162. The second channel part CN2 is disposed between the gate electrode 150 and the drain electrode 162.

The first channel part CN1 and the second channel part CN2 have a semiconductor characteristic. Depending on the voltage applied to the gate electrode 150, the first channel part CN1 and the second channel part CN2 may have an electrical characteristic like a conductor or electrical characteristic like an insulator.

The connection part 130c connects the first channel part CN1 and the second channel part CN2. Referring to FIG. 1 and FIG. 2, the connection part 130c is disposed between the first channel part CN1 and the second channel part CN2. A first side (e.g., a first end) of the connection part 130c may be contact the first channel part CN1 and a second side (e.g., a second end) of the connection part 130c that is opposite the first side may be contact the second channel part CN2.

Referring to FIG. 1 and FIG. 2, the connection part 130c may overlap with the gate electrode 150. The connection part 130c may be disposed on the gate electrode 150.

According to one embodiment of the present disclosure, the connection part 130c is a conductorized region. In detail, the connection part 130c is a region where a portion of the semiconductor material constituting the active layer 130 is selectively conductorized.

According to one embodiment of the present disclosure, the connection part 130C may be referred to as a conductorized portion.

According to one embodiment of the present disclosure, a connection part 130c may be formed by selective conductorization of the active layer 130. In detail, a portion of the oxide semiconductor material constituting the active layer 130 may be conductorized, thereby forming a connection part 130c.

According to one embodiment of the present disclosure, the connection part 130c is formed by selective conductorization of the active layer 130. For example, the connection part 130c may be formed by selectively conductorizing an oxide semiconductor material constituting the active layer 130. According to one embodiment of the present disclosure, the selective conductorization may also be referred to as metallization.

According to one embodiment of the present disclosure, selective conductorization refers to improving the electrical conductivity of a selected portion of the active layer 130 or imparting electrical conductivity to the selected portion. The selectively conductorized portion of the active layer 130 may have excellent electrical conductivity.

According to one embodiment of the present disclosure, for example, a region of the active layer 130 that does not overlap (e.g., non-overlapping) with either the source electrode 161 or the drain electrode 162 may be selectively conductorized. Accordingly, according to one embodiment of the present disclosure, the connection part 130c does not overlap (e.g., non-overlapping) with the source electrode 161 or the drain electrode 162.

As a result of the conductorization, the connection part 130c may have an electrical property similar to a conductor. In detail, the connection part 130c may have electrical property similar to a metal.

On the other hand, the first channel part CN1 and the second channel part CN2 are non conductorized regions.

As a result of the selective conductorization, the connection part 130c may have a higher carrier concentration than the first channel part CN1 and the second channel part CN2. The carrier concentration of the connection part 130c may be higher than the carrier concentration of the first channel part CN1 and the carrier concentration of the second channel part CN2.

For example, when the thin film transistor 100 is in the off state, the first channel part CN1 and the second channel part CN2 may each have a carrier concentration of about 1.0 x 10¹⁶ ea/cm³ to 1.0 x 10¹⁸ ea/cm³. The connection part 130c may have a carrier concentration of 1.0 x 10²¹ ea/cm³ or more.

Additionally, the connection part 130c may have a lower resistivity than the first channel part CN1 and the second channel part CN2. For example, the connection part 130c may have a resistivity of 10⁻⁴ Ω·cm or less. When the thin film transistor 100 is in an off state, the first channel part CN1 and the second channel part CN2 may each have a resistivity of about 10⁻⁵ Ω·cm to 10⁸ Ω·cm.

According to one embodiment of the present disclosure, selective conductorization of the active layer 130 may be performed by dopant doping, dry etching, or plasma treatment.

According to one embodiment of the present disclosure, doping may be performed by ion implantation. For example, selective conductorization may be performed by doping dopant ions into a selected region of the active layer 130 by ion implantation using the source electrode 161 and the drain electrode 162 as masks. According to one embodiment of the present disclosure, the dopant may include at least one of boron (B), phosphorus (P), fluorine (F), arsenic (As), and hydrogen (H).

When selective conductorization is achieved for the active layer 130 by dopant ion implantation, the connection part 130c may be doped with the dopant. On the other hand, the first channel part CN1 and the second channel part CN2 are prevented from being doped with the dopant. Therefore, according to one embodiment of the present disclosure, the connection part 130c may be defined as a region doped with the dopant. The dopant concentration of the connection part 130c may be higher than the dopant concentration of the first channel part CN1 and the dopant concentration of the second channel part CN2. Here, the dopant may include at least one of boron (B), phosphorus (P), fluorine (F), arsenic (As), and hydrogen (H).

Additionally, the connection part 130c may have a higher dopant concentration than the first contact part 130a and the second contact part 130b.

However, one embodiment of the present disclosure is not limited thereto, and the connection part 130c may be formed by another method. According to one embodiment of the present disclosure, the connection part 130c may be formed by selectively conductorizing the active layer 130 by dry etching or plasma treatment. For example, dry etching or plasma treatment may be performed during the process of patterning the interlayer insulating layer 170 or forming contact holes CH1, CH2 in the interlayer insulating layer 170, and at this time, selective conductorization may be performed to form the connection part 130c.

When selective conductorization of the active layer 130 is performed by dry etching or plasma treatment, a hydrogen (H) concentration of the connection part 130c may be higher than a hydrogen (H) concentration of the first channel part CN1 and a hydrogen (H) concentration of the second channel part CN2.

The source electrode 161 is connected to the active layer 130 through a first contact hole CH1 formed in the interlayer insulating layer 170. The drain electrode 162 is connected to the active layer 130 through a second contact hole CH2 formed in the interlayer insulating layer 170.

According to one embodiment of the present disclosure, during the process of forming the first contact hole CH1 for connecting the source electrode 161 and the active layer 130, a part of the active layer 130 may be conductorized.

In the process of forming the first contact hole CH1, a part of the active layer 130 may be conductorized. For example, a region of the active layer 130 overlapping the first contact hole CH1 and a surrounding region thereof may be selectively conductorized. The region of the active layer 130 that is conductorized in the process of forming the first contact hole CH1 may have a higher hydrogen (H) concentration than the first channel part CN1. Alternatively, the region of the active layer 130 that is conductorized in the process of forming the first contact hole CH1 may have a lower oxygen (O) concentration than the first channel part CN1.

According to one embodiment of the present disclosure, a portion of the active layer 130 that contacts the source electrode 161 is referred to as a first contact part 130a. The first contact part 130a is a region of the active layer 130 that is exposed from the interlayer insulating layer 170. The first contact part 130a may be connected to the source electrode 161 through a first contact hole CH1 formed in the interlayer insulating layer 170.

According to one embodiment of the present disclosure, the first contact part 130a is a conductorized region, and a portion of the surrounding area of the first contact part 130a may also be conductorized. As a result, the electrical signal of the source electrode 161 may be transmitted to the first channel part CN1 of the active layer 130.

Additionally, during the process of forming the second contact hole CH2, a part of the active layer 130 may be conductorized. For example, a region of the active layer 130 overlapping the second contact hole CH2 and a surrounding region thereof may be selectively conductorized. The region of the active layer 130 that is conductorized during the process of forming the second contact hole CH2 may have a higher hydrogen (H) concentration than the second channel part CN2. Additionally, the region of the active layer 130 that is conductorized during the process of forming the second contact hole CH2 may have a lower oxygen (O) concentration than the second channel part CN2.

According to one embodiment of the present disclosure, a portion of the active layer 130 that contacts the drain electrode 162 is referred to as a second contact part 130b. The second contact part 130b is a region of the active layer 130 that is exposed from the interlayer insulating layer 170. The second contact part 130b may be connected to the drain electrode 162 through a second contact hole CH2 formed in the interlayer insulating layer 170.

According to one embodiment of the present disclosure, the second contact part 130b is a conductorized region. Additionally, a portion of the surrounding area of the second contact part 130b may also be conductorized. As a result, the electrical signal of the second channel part CN2 may be transmitted to the drain electrode 162.

Meanwhile, when the connection part 130c is formed by dopant doping using the source electrode 161 and the drain electrode 162 as masks, the first contact part 130a is covered by the source electrode 161, and the second contact part 130b is covered by the drain electrode 162. As a result, the first contact part 130a and the second contact part 130b will not be doped. Accordingly, the first contact part 130a and the second contact part 130b may have a lower dopant concentration than the connection part 130c.

According to one embodiment of the present disclosure, the active layer 130 may include a first contact part 130a contacting the source electrode 161. Additionally, the active layer 130 may include a second contact part 130b contacting the drain electrode 162.

Referring to FIG. 1 and FIG. 2, the first channel part CN1 may be disposed between the connection part 130c and the first contact part 130a. A first side of the first channel part CN1 is connected to the first contact part 130a and a second side of the first channel part CN1 that is opposite the first side is connected to the connection part 130c. The second channel part CN2 may be disposed between the connection part 130c and the second contact part 130b. A first side of the second channel part CN2 is connected to the connection part 130c and a second side of the second channel part CN2 is connected to the second contact part 130b.

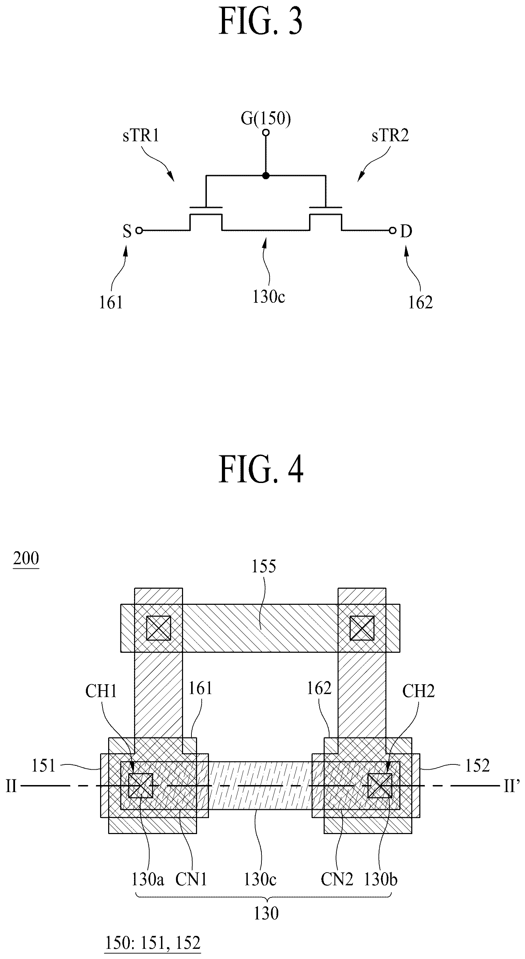

FIG. 3 is a circuit diagram of a thin film transistor 100 according to one embodiment of the present disclosure.

Referring to FIG. 3, a thin film transistor 100 according to one embodiment of the present disclosure corresponds to a structure in which two sub-transistors sTR1 and sTR2 are connected in series.

A thin film transistor 100 according to one embodiment of the present disclosure may include a first sub-transistor sTR1 and a second sub-transistor sTR2. The first sub-transistor sTR1 and the second sub-transistor sTR2 are connected in series.

In the thin film transistor 100 illustrated in FIG. 1 and FIG. 2, the gate electrode 150 may be the gate electrode G of each of the first sub-transistor sTR1 and the second sub-transistor sTR2.

The first channel part CN1 of the thin film transistor 100 illustrated in FIG. 1 and FIG. 2 may serve as a channel part of the first sub-transistor sTR1, and the second channel part CN2 may serve as a channel part of the second sub-transistor sTR2.

The source electrode 161 of the thin film transistor 100 illustrated in FIG. 1 and FIG. 2 may become the source electrode S of the first sub-transistor sTR1. The connection part 130c of the thin film transistor 100 illustrated in FIG. 1 and FIG. 2 may become the drain electrode of the first sub-transistor sTR1.

Additionally, the connection part 130c of the thin film transistor 100 illustrated in FIG. 1 and FIG. 2 may become the source electrode of the second sub-transistor sTR2. The drain electrode 162 of the thin film transistor 100 illustrated in FIG. 1 and FIG. 2 may become the drain electrode D of the second sub-transistor sTR2.

The first sub-transistor sTR1 may include a gate electrode 150, a channel part CN1, a source electrode 161, and a drain electrode 130c. The second sub-transistor sTR2 may include a gate electrode 150, a channel part CN2, a source electrode 130c, and a drain electrode 162.

According to one embodiment of the present disclosure, since a voltage is applied to the source electrode 161, an effect of applying an electric field to both the upper and lower sides of the first channel part CN1 may be generated. At this time, a constant source voltage is applied to the source electrode 161, and a saturation driving effect in which a constant voltage flows through the first channel part CN1 may be generated.

According to one embodiment of the present disclosure, when the interlayer insulating layer 170 has a similar thickness to the gate insulating layer 140, the first sub-transistor sTR1 may have electrical characteristic of a double gate structure.

Additionally, when the thicknesses of the interlayer insulating layer 170 and the gate insulating layer 140 are different, an effect of applying a bias voltage that changes the threshold voltage by the source electrode occurs, thereby enabling the threshold voltage of the first sub-transistor sTR1 to be controlled.

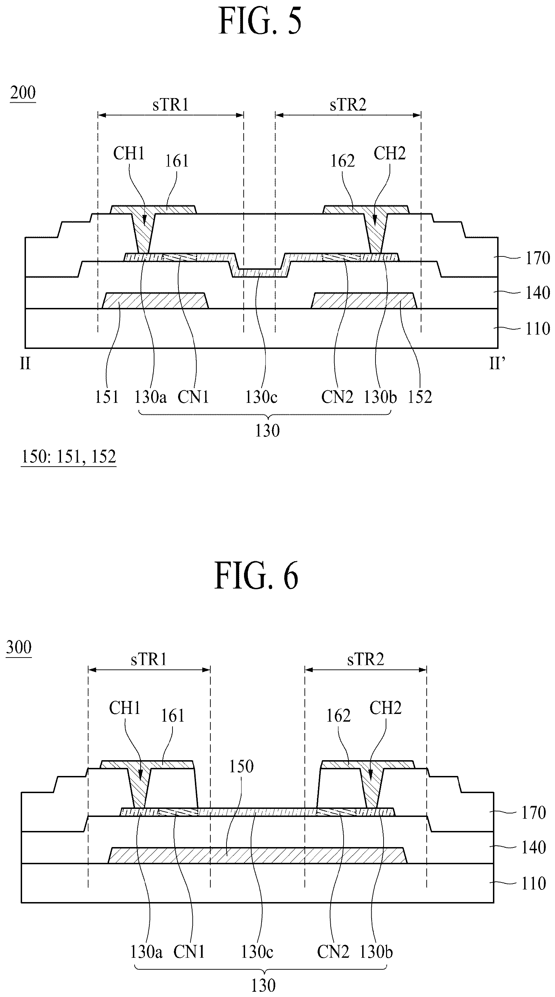

According to one embodiment of the present disclosure, since a voltage is applied to the drain electrode 162, an effect of applying an electric field to both the upper and lower portions of the second channel part CN2 may occur. When the interlayer insulating layer 170 has a similar thickness to the gate insulating layer 140, the second sub-transistor sTR1 may have electrical characteristic of a double gate structure. Additionally, when the thicknesses of the interlayer insulating layer 170 and the gate insulating layer 140 are different, an effect of applying a bias voltage that changes the threshold voltage by the drain electrode 182 occurs, so that the threshold voltage of the second sub-transistor sTR2 may be controlled. FIG. 4 is a plan view of a thin film transistor 200 according to an embodiment of the present disclosure, and FIG. 5 is a cross-sectional view taken along line II-II' of FIG. 4 according to one embodiment.

Hereinafter, to avoid duplication, descriptions of components already described are omitted, or components already described are briefly described.

Referring to FIG. 4 and FIG. 5, at least a portion of the connection part 130c may not overlap the gate electrode 150.

In detail, according to an embodiment of the present disclosure, the gate electrode 150 may include a first gate electrode 151 and a second gate electrode 152. The first gate electrode 151 overlaps the first channel part CN1 and the source electrode 161. The second gate electrode 151 may overlap the second channel part CN2 and the drain electrode 162. The first gate electrode 151 and the second gate electrode 152 may be connected to each other through the connection electrode 155.

Referring to FIG. 4 and FIG. 5, at least a portion of the connection part 130c does not overlap (e.g., non-overlapping) with the first gate electrode 151 and the second gate electrode 152. In detail, at least a portion of the connection part 130c may not overlap with either the first gate electrode 151 or the second gate electrode 152.

FIG. 6 is a cross-sectional view of a thin film transistor 300 according to an embodiment of the present disclosure.

Referring to FIG. 6, the thin film transistor 300 includes an interlayer insulating layer 170 disposed between the active layer 130 and the source electrode 161 and between the active layer 130 and the drain electrode 162. The connection part 130c is exposed from the interlayer insulating layer 170. That is, the interlayer insulating layer 170 is non-overlapping with the connection part 130c.

Referring to FIG. 6, in the process of patterning the interlayer insulating layer 170 to expose a part of the active layer 130 from the interlayer insulating layer 170, a part of the active layer 130 may be conductorized.

For example, in order to expose a part of the active layer 130 from the interlayer insulating layer 170, a part of the interlayer insulating layer 170 may be removed by a dry etching method. During this dry etching process, a part of the active layer 130 may be selectively conductorized to form a connection part 130c.

Additionally, selective conductorization for the active layer 130 may be performed by plasma treating the region of the active layers 130 exposed from the interlayer insulating layer 170. As a result, a connection part 130c may be formed.

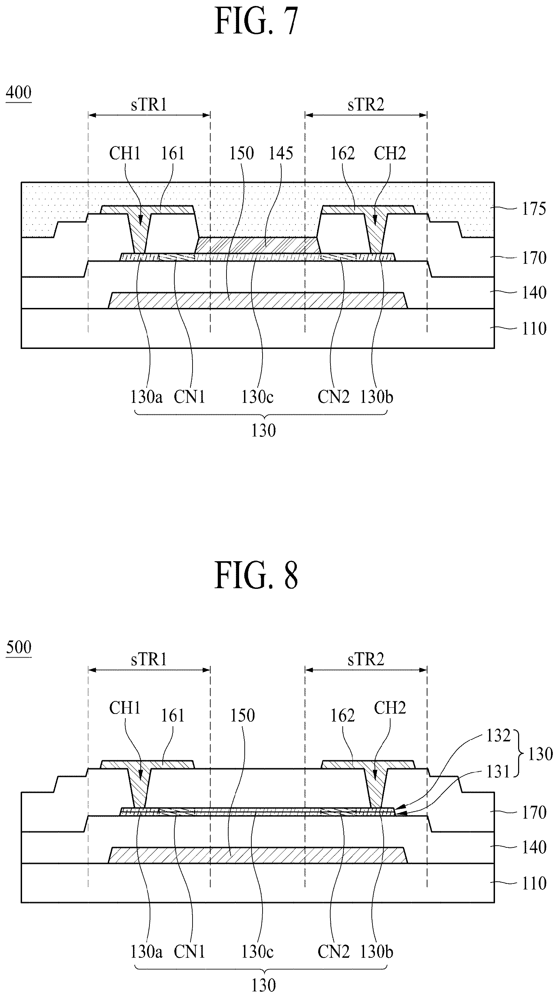

FIG. 7 is a cross-sectional view of a thin film transistor 400 according to an embodiment of the present disclosure.

Referring to FIG. 7, a thin film transistor 400 according to an embodiment of the present disclosure may further include a capping layer 145 disposed on a connection part 130c. The capping layer 145 is in contact with the connection part 130c. The capping layer 145 has a reducing property (as same as reducibility).

According to an embodiment of the present disclosure, reducing property refers to the property of reducing another substance. When a substance has a reducing property, it means that the substance has the property of reducing another substance when oxidized. A reducing substance has the characteristic of being oxidized itself and has the property of reducing another substance.

According to an embodiment of the present disclosure, since the capping layer 145 has a reducing property, it may reduce other substances. According to an embodiment of the present disclosure, the capping layer 145 is made of a material that is easily oxidized and can reduce other substances.

According to an embodiment of the present disclosure, the capping layer 145 may contact the active layer 130.

The region of the active layer 130 contacting the capping layer 145 may be selectively reduced. As a result of this reduction, a region of the active layer 130 contacting the capping layer 145 has characteristic similar to metal and may be made conductorized.

According to an embodiment of the present disclosure, the active layer 130 may be selectively conductorized by the capping layer 145, thereby forming a connection part 130c.

The capping layer 145 may include a reducing material. For example, the capping layer 145 may include at least one of titanium (Ti), molybdenum (Mo), aluminum (Al), indium (In), and zinc (Zn). The capping layer 145 may also include a metal oxide. The capping layer may include, for example, at least one of an IZO (InZnO) based oxide, an IGZO (InGaZnO) based oxide, an ITO (InSnO) based oxide, an InO based oxide, a ZnON based oxide, and a ZnO based oxide having a low oxygen concentration. When an oxide including indium and a different metal is used as the capping layer 145, the content of indium may be 50% or more based on the number of atoms relative to the total metal content.

The oxide applied to the capping layer 145 has a low oxidation number and may be easily oxidized. The oxide applied to the capping layer 145 may include a lower content of oxygen (O) than the content of oxygen (O) when it is recognized as a stoichiometrically stable state. As a result, when the capping layer 145 contacts the active layer 130, the capping layer 145 is oxidized, and a portion of the active layer 130 contacting the capping layer 145 may be reduced. As a result, a portion of the active layer 130 contacting the capping layer 145 has property close to metal and may become a connection part 130c.

A passivation layer 175 may be disposed on the capping layer 145. The passivation layer 175 protects the active layer 130 and the capping layer 145.

FIG. 8 is a cross-sectional view of a thin film transistor 500 according to an embodiment of the present disclosure.

Referring to FIG. 8, the active layer 130 may include a first oxide semiconductor layer 131 and a second oxide semiconductor layer 132 on the first oxide semiconductor layer 131.

The first oxide semiconductor layer 131 may serve as a support layer supporting the second oxide semiconductor layer 132. The second oxide semiconductor layer 132 may serve as a main channel layer.

The first oxide semiconductor layer 131 serving as a support layer may have excellent film stability and mechanical stability. The first oxide semiconductor layer 131 may include, for example, at least one of an IGO (InGaO) based, IGZO (InGaZnO) based, IGZTO (InGaZnSnO) based, GZTO (GaZnSnO) based, GZO (GaZnO) based, and GO (GaO) based oxide semiconductor material. However, one embodiment of the present disclosure is not limited thereto, and the first oxide semiconductor layer 131 may be made of other oxide semiconductor materials known in the art.

The second oxide semiconductor layer 132 may include at least one of oxide semiconductor materials, such as IZO (InZnO) based, FIZO (FeInZnO) based, TO (SnO) based, IGO (InGaO) based, ITO (InSnO) based, IGZO (InGaZnO) based, IGZTO (InGaZnSnO) based, GZTO (GaZnSnO) based, ITZO (InSnZnO) based, and IO (InO) based, for example. However, one embodiment of the present disclosure is not limited thereto, and the second oxide semiconductor layer 132 may be formed by other oxide semiconductor materials known in the art.

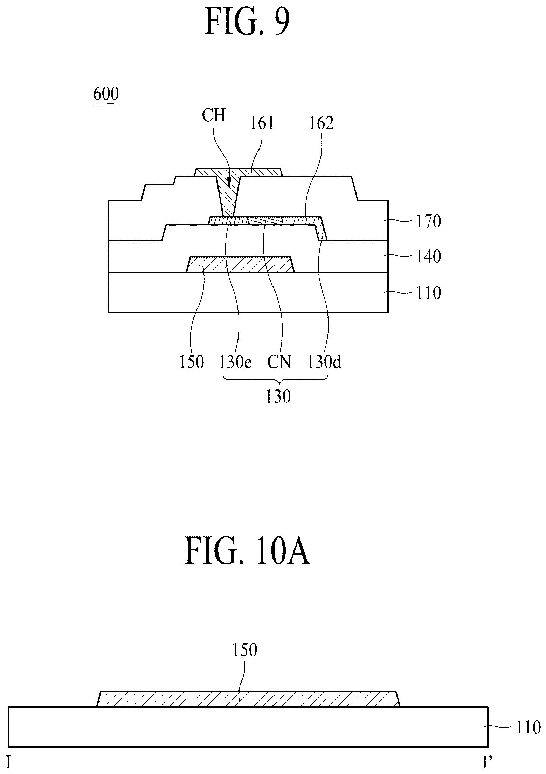

FIG. 9 is a cross-sectional view of a thin film transistor 600 according to an embodiment of the present disclosure.

A thin film transistor 600 according to an embodiment of the present disclosure includes a gate electrode 150, an active layer 130 spaced apart from the gate electrode 150 and at least partially overlapping the gate electrode 150, and a source electrode 161 connected to the active layer 130.

The active layer 130 includes a channel part CN, a connection part 130d, and a contact part 130e.

Referring to FIG. 9, the channel part CN of the active layer 130 overlaps with the source electrode 161 and the gate electrode 150. The channel part CN is disposed between the connection part 130d and the contact part 130e.

The contact part 130e may contact the source electrode 161. The contact part 130e may contact the source electrode 161 through the contact hole CH.

The connection part 130d does not overlap (e.g., non-overlapping) with the source electrode 161. The connection part 130d is a conductorized region. In detail, the connection part 130d is a region where a portion of the semiconductor material constituting the active layer 130 is selectively conductorized. As a result of the selective conductorization, the connection part 130d may have a higher carrier concentration than the channel part CN1.

In the case where selective conductorization for the active layer 130 is performed by dopant ion implantation using the source electrode 161 as a mask, the connection part 130d may be doped with the dopant. On the other hand, the channel part CN is prevented from being doped with the dopant. Therefore, according to one embodiment of the present disclosure, the dopant concentration of the connection part 130c may be higher than the dopant concentration of the channel part CN. Here, the dopant may include at least one of boron (B), phosphorus (P), fluorine (F), arsenic (As), and hydrogen (H).

Meanwhile, when the connection part 130d is formed by dopant doping using the source electrode 161 as a mask, the contact part 130e is covered by the source electrode 161, and no doping will occur in the contact part 130e. Accordingly, the contact part 130e may have a lower dopant concentration than the connection part 130d.

According to an embodiment of the present disclosure, the connection part 130d is connected to one side of the channel part CN. Therefore, the connection part 130d may serve as a drain connection part, and the connection part 130d may serve as a drain electrode 162. Therefore, according to an embodiment of the present disclosure, the connection part 130d may also be referred to as a drain electrode 162. In one embodiment, a first end of the connection part 130d that is connected to the channel part CN is at a first height with respect to the substrate 110 that is higher than a height of a second end of the connection part 130. In one embodiment, the second end of the connection part 130d is on a side surface of the gate insulating layer 140.

In the embodiments of the present disclosure, the source electrode 161 and the drain electrode 162 are distinguished only for convenience of explanation, and the source electrode 161 and the drain electrode 162 may be interchanged. In FIG. 9, the source electrode 161 may serve as the drain electrode, and the connection part 130d may serve as the source electrode.

FIGs. 10A to 10E are schematic cross-sectional views illustrating a manufacturing method for a thin film transistor 100 according to an embodiment of the present disclosure.

A method for manufacturing a thin film transistor 100 according to an embodiment of the present disclosure includes forming a gate electrode 150 on a substrate 110, forming an active layer 130 on the gate electrode, the active layer 130 being spaced apart from the gate electrode150, forming an interlayer insulating layer 170 having a contact hole on the active layer 130, forming a source electrode 161 and a drain electrode 162 on the interlayer insulating layer 170, and conducting the active layer 130 selectively using the source electrode 161 and the drain electrode 162 as masks.

First, referring to FIG. 10A, a gate electrode 150 is formed on a substrate 110.

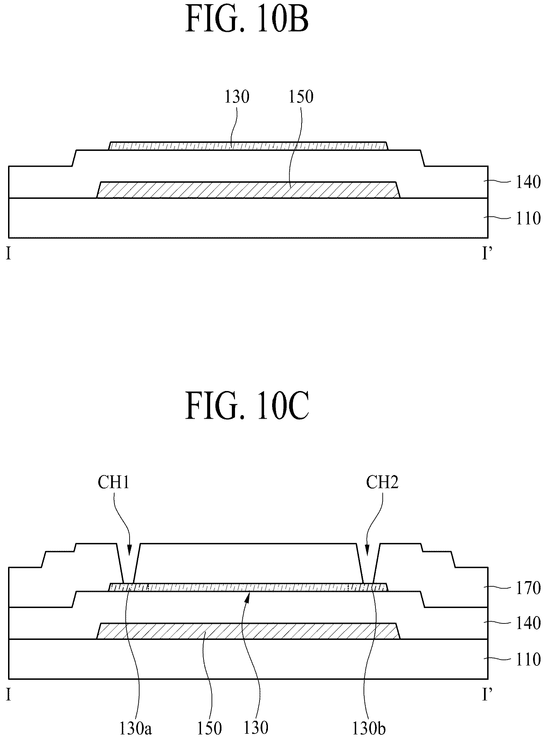

Next, referring to FIG. 10B, a gate insulating layer 140 is formed on a gate electrode 150, and an active layer 130 is formed on the gate insulating layer 140.

The active layer 130 is formed on the gate electrode 150 so as to be spaced apart from the gate electrode 150 and to overlap at least partially with the gate electrode 150.

Referring to FIG. 10C, an interlayer insulating layer 170 is formed on the active layer 130. The interlayer insulating layer 170 has contact holes CH1, CH2. A part of the active layer 130 may be exposed from the interlayer insulating layer 170 by the contact holes CH1, CH2.

During the forming contact holes CH1, CH2, the active layer 130 may be selectively conductorized to form a first contact part 130a and a second contact part 130b.

In detail, in the process of forming the first contact hole CH1, the area of the active layer 130 exposed by the first contact hole CH1 and the surrounding area may be selectively conductorized. As a result, the first contact part 130a may be formed.

Additionally, in the process of forming the second contact hole CH2, the area of the active layer 130 exposed by the second contact hole CH2 and the surrounding area may be selectively conductorized. As a result, the second contact part 130b may be formed.

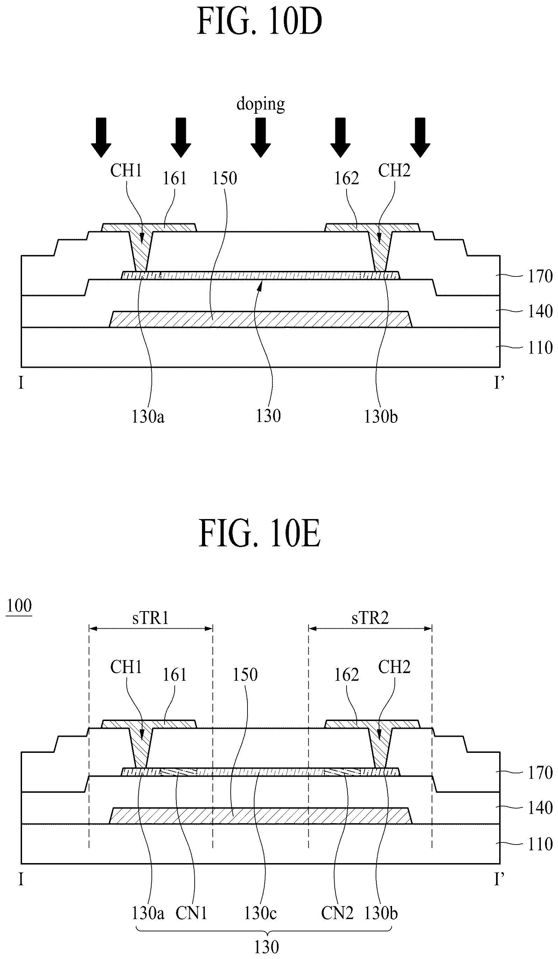

Referring to FIG. 10D, a source electrode 161 and a drain electrode 162 are formed on an interlayer insulating layer 170. The source electrode 161 and the drain electrode 162 are spaced apart from each other and each is connected to the active layer 130.

The source electrode 161 is connected to the active layer 130 through the first contact hole CH1. The source electrode 161 may come the first contact part 130a of the active layer 130.

The drain electrode 162 is connected to the active layer 130 through the second contact hole CH2. The drain electrode 162 may contact the second contact part 130b of the active layer 130.

Next, as illustrated in FIG. 10D, the active layer 130 is selectively conductorized using the source electrode 161 and the drain electrode 162 as masks. The selective conductorization refers to improving the electrical conductivity of a selected portion or imparting electrical conductivity to a selected portion.

According to an embodiment of the present disclosure, selective conductorization of the active layer 130 may be performed by dopant doping, dry etching, or plasma treatment.

Referring to FIG. 10D, selective conductorization may be performed by dopant doping. Dopant doping may be performed by ion implantation. For example, selective conductorization may be performed by doping dopant ions into a selected region of the active layer 130 by ion implantation using the source electrode 161 and the drain electrode 162 as masks. According to one embodiment of the present disclosure, the dopant may include at least one of boron (B), phosphorus (P), fluorine (F), arsenic (As), and hydrogen (H).

Referring to FIG. 10E, a connection part 130c is formed as a result of selective conductorization of the active layer 130. As a result, a thin film transistor 100 according to an embodiment of the present disclosure may be produced.

An embodiment of the present disclosure provides a display apparatus including the thin film transistor 100, 200, 300, 400, 500, 600 described above.

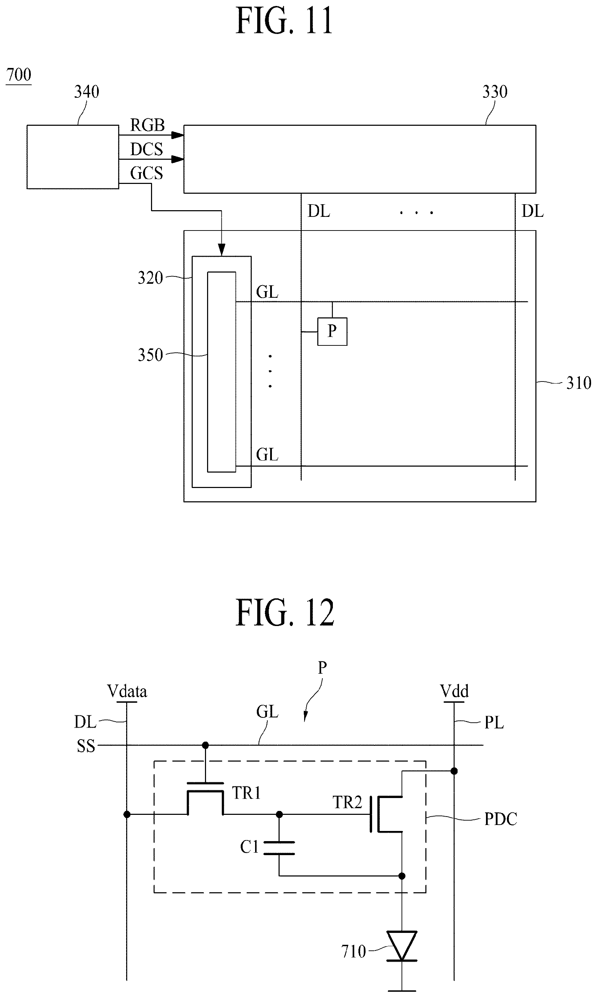

FIG. 11 is a schematic diagram of a display apparatus 700 according to an embodiment of the present disclosure.

The display apparatus 700 according to an embodiment of the present disclosure includes a display panel 310, a gate driver 320, a data driver 330, and a control unit 340 (e.g., a circuit), as illustrated in FIG. 11.

The gate lines GL and data lines DL are disposed on the display panel 310, and pixels P are arranged in the intersection area of the gate lines GL and data lines DL. An image is displayed by driving the pixels P.

The control unit 340 controls the gate driver 320 and the data driver 330.

The control unit 340 outputs a gate control signal GCS for controlling the gate driver 320 and a data control signal DCS for controlling the data driver 330 using a signal supplied from an external system. Additionally, the control unit 340 samples input image data input from an external system, rearranges it, and supplies rearranged digital image data RGB to the data driver 330.

The gate control signal GCS includes a gate start pulse GSP, a gate shift clock GSC, a gate output enable signal GOE, a start signal Vst, and a gate clock GCLK. Additionally, the gate control signal GCS may include control signals for controlling the shift register 350.

Data control signals DCS include source start pulse SSP, source shift clock signal SSC, source output enable signal SOE, and polarity control signal POL.

The data driver 330 supplies data voltage to the data lines DL of the display panel 310. In detail, the data driver 330 converts image data RGB input from the control unit 340 into analog data voltage and supplies the data voltage to the data lines DL.

The gate driver 320 may include a shift register 350.

The shift register 350 sequentially supplies gate pulses to the gate lines GL for one frame using a start signal and a gate clock transmitted from the control unit 340. Here, one frame refers to a period during which one image is output through the display panel 310. The gate pulse has a turn-on voltage capable of turning on a switching element thin film transistor arranged in a pixel P.

Additionally, the shift register 350 supplies a gate off signal capable of turning off the switching element to the gate line GL during the remaining period during which the gate pulse is not supplied during one frame. Hereinafter, the gate pulse and the gate off signal are collectively referred to as a scan signal SS or Scan.

According to one embodiment of the present disclosure, the gate driver 320 may be mounted on the substrate 110. As described above, a structure in which the gate driver 320 is directly mounted on the substrate 110 is called a Gate In Panel GIP structure. The gate driver 320 may include at least one of the thin film transistors 100, 200, 300, 400, 500 described above.

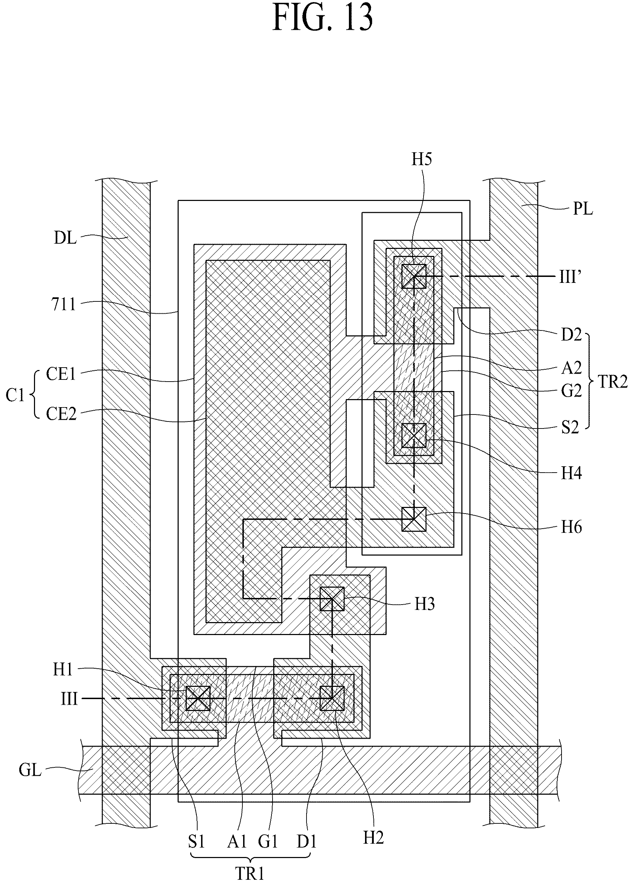

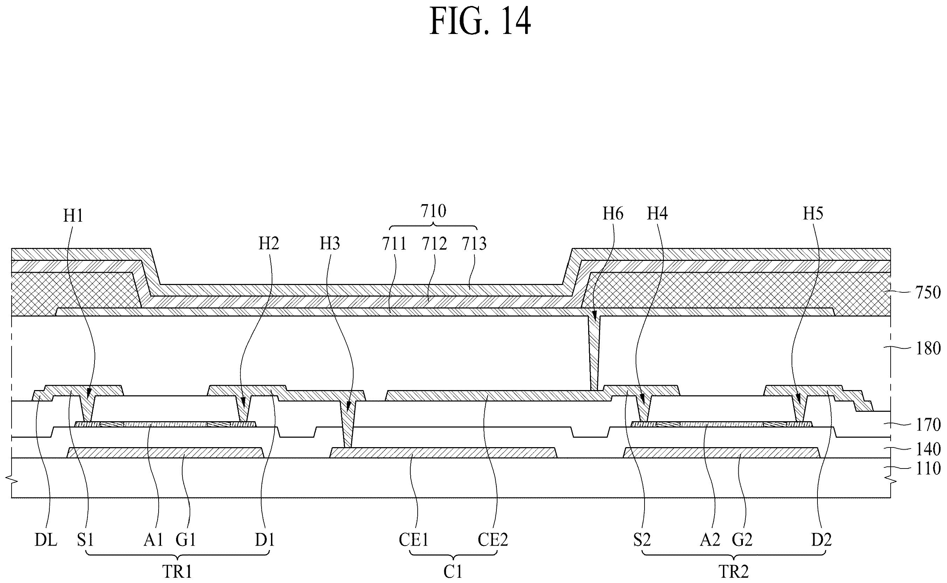

FIG. 12 is a circuit diagram for one pixel P of FIG. 11, FIG. 13 is a plan view for the pixel P of FIG. 12 according to one embodiment and FIG. 14 is a cross-sectional view taken along line III-III' of FIG. 13 according to one embodiment.

The circuit diagram of FIG. 12 is an equivalent circuit diagram for a pixel P of a display apparatus 700 including an organic light emitting diode OLED as a display element 710 or a light-emitting element.

The pixel P includes a display element 710 and a pixel driver PDC that drives the display element 710.

The pixel driver PDC of FIG. 12 includes a first thin film transistor TR1 which is a switching transistor and a second thin film transistor TR2 which is a driving transistor.

A display apparatus 700 according to an embodiment of the present disclosure may include at least one of the thin film transistors 100, 200, 300, 400, 500, 600 described above. As the first thin film transistor TR1 or the second thin film transistor TR2 of FIG. 12, any one of the thin film transistors 100, 200, 300, 400, 500, 600 described above may be used.

The first thin film transistor TR1 is connected to the gate line GL and the data line DL, and is turned on or off by the scan signal SS supplied through the gate line GL.

The data line DL provides a data voltage Vdata to the pixel driver PDC, and the first thin film transistor TR1 controls the application of the data voltage Vdata.

The driving power line PL provides a driving voltage Vdd to the display element 710, and the second thin film transistor TR2 controls the driving voltage Vdd. The driving voltage Vdd is a pixel driving voltage for driving the organic light emitting diode OLED, which is the display element 710.

When the first thin film transistor TR1 is turned on by a scan signal SS applied through the gate line GL from the gate driver 320, the data voltage Vdata supplied through the data line DL is supplied to the gate electrode G2 of the second thin film transistor TR2 connected to the display element 710. The data voltage Vdata is charged in the first capacitor C1 formed between the gate electrode G2 and the source electrode S2 of the second thin film transistor TR2. The first capacitor C1 is a storage capacitor Cst.

The amount of current supplied to the organic light emitting diode OLED, which is a display element 710, through the second thin film transistor TR2 is controlled according to the data voltage Vdata, and accordingly, the gradation of light output from the display element 710 may be controlled.

Referring to FIG. 13 and FIG. 14, a first thin film transistor TR1 and a second thin film transistor TR2 are disposed on a substrate 110.

The substrate 110 may be made of glass or plastic. As the substrate 110, a plastic having flexible property, for example, polyimide PI, may be used. A buffer layer may also be disposed on the substrate 110.

A gate electrode G1 of a first thin film transistor TR1 and a gate electrode G2 of a second thin film transistor TR2 are disposed on a substrate 110.

Also, referring to FIG. 13 and FIG. 14, a first capacitor electrode CE1 is disposed on the same layer as the gate electrodes G1, G2. The gate electrodes G1, G2 and the first capacitor electrode CE1 may be manufactured together by the same process using the same material.

A gate insulating layer 140 is disposed on the gate electrodes G1, G2 and the first capacitor electrode CE1. The gate insulating layer 140 has insulating property and separates the active layers A1, A2 from the gate electrodes G1, G2. As illustrated in FIG. 14, the gate insulating layer 140 may not be patterned. However, an embodiment of the present disclosure is not limited thereto, and the gate insulating layer 140 may be patterned.

An active layer A1 of a first thin film transistor TR1 and an active layer A2 of a second thin film transistor TR2 are disposed on a gate insulating layer 140.

The active layers A1, A2 may include an oxide semiconductor material. According to an embodiment of the present disclosure, the active layers A1, A2 are oxide semiconductor layers made of an oxide semiconductor material.

The active layer A1 of the first thin film transistor TR1 overlaps with the gate electrode G1 of the first thin film transistor TR1. The active layer A2 of the second thin film transistor TR2 overlaps with the gate electrode G2 of the second thin film transistor TR2.

An interlayer insulating layer 170 is disposed on the active layer A1, A2.

A source electrode S1, S2 and a drain electrode D1, D2 are disposed on an interlayer insulating layer 170. According to one embodiment of the present disclosure, the source electrode S1, S2 and the drain electrode D1, D2 are distinguished only for convenience of explanation, and the source electrode S1, S2 and the drain electrode D1, D2 may be interchanged.

Additionally, a data line DL and a driving power line PL are disposed on the interlayer insulating layer 170. The source electrode S1 of the first thin film transistor TR1 may be formed integrally with the data line DL. The drain electrode D2 of the second thin film transistor TR2 may be formed integrally with the driving power line PL.

According to one embodiment of the present disclosure, the source electrode S1 and the drain electrode D1 of the first thin film transistor TR1 are spaced apart from each other and are respectively connected to the active layer A1 of the first thin film transistor TR1. The source electrode S2 and the drain electrode D2 of the second thin film transistor TR2 are spaced apart from each other and are respectively connected to the active layer A2 of the second thin film transistor TR2.

In detail, the source electrode S1 of the first thin film transistor TR1 is connected to the active layer A1 through the first contact hole H1.

The drain electrode D1 of the first thin film transistor TR1 is connected to the active layer A1 through the second contact hole H2 and to the first capacitor electrode CE1 through the third contact hole H3.

The source electrode S2 of the second thin film transistor TR2 extends over the interlayer insulating layer 170, and a portion of it functions as a second capacitor electrode CE2. The first capacitor electrode CE1 and the second capacitor electrode CE2 overlap to form a first capacitor C1.

The source electrode S2 of the second thin film transistor TR2 is connected to the active layer A2 through the fourth contact hole H4. The drain electrode D2 of the second thin film transistor TR2 is connected to the active layer A2 through the fifth contact hole H5.

The first thin film transistor TR1 includes an active layer A1, a gate electrode G1, a source electrode S1, and a drain electrode D1, and acts as a switching transistor that controls the data voltage Vdata applied to the pixel driver PDC.

The second thin film transistor TR2 includes an active layer A2, a gate electrode G2, a source electrode S2, and a drain electrode D2, and acts as a driving transistor that controls the driving voltage Vdd applied to the display element 710.

A planarization layer 180 is disposed on the source electrodes S1, S2, the drain electrodes D1, D2, the data line DL, the driving power line PL, and the second capacitor electrode CE2. The planarization layer 180 planarizes the upper portions of the first thin film transistor TR1 and the second thin film transistor TR2, and protects the first thin film transistor TR1 and the second thin film transistor TR2.

A first electrode 711 of a display element 710 is disposed on a planarization layer 180. The first electrode 711 of the display element 710 is connected to a source electrode S2 of a second thin film transistor TR2 through a seventh contact hole H7 formed in the planarization layer 180.

A bank layer 750 is arranged at the edge of the first electrode 711. The bank layer 750 defines the light emitting area of the display element 710.

An organic light emitting layer 712 is disposed on a first electrode 711, and a second electrode 713 is disposed on the organic light emitting layer 712. Accordingly, a display element 710 is completed. The display element 710 illustrated in FIG. 14 is the organic light emitting diode OLED. Therefore, a display apparatus 100 according to an embodiment of the present disclosure is an organic light emitting display apparatus.

A pixel driver PDC according to an embodiment of the present disclosure may be formed in various structures other than the structures described above. The pixel driver PDC may include, for example, three or more thin film transistors and two or more capacitors.

The present disclosure described above is not limited to the above-described embodiments and the attached drawings, and it will be apparent to a person skilled in the art to which the present disclosure pertains that various substitutions, modifications, and changes are possible within a scope that does not depart from the technical details of the present disclosure.

According to one embodiment of the present disclosure, since conductorizing is performed using a source electrode and a drain electrode, a short channel may be easily formed in a thin film transistor.

According to one embodiment of the present disclosure, in the method of manufacturing a thin film transistor, since the channel part is defined by the source electrode and the drain electrode, the channel part can be defined by self-alignment. As a result, the channel part is easily defined, and thus a short channel may be easily formed.

According to one embodiment of the present disclosure, a plurality of thin film transistors having short channel may be formed on one substrate, and the plurality of thin film transistors may have excellent uniformity of properties.

The display apparatus according to one embodiment of the present disclosure may include a plurality of thin film transistors having a short channel and excellent uniformity of properties. Additionally, a plurality of thin film transistors may be disposed at a high density in the display apparatus. Therefore, a display apparatus according to one embodiment of the present disclosure may exhibit high resolution images stably, and may have a stable and high resolution display performance.

In addition to the effects mentioned above, other features and advantages of the present disclosure are described below or may be clearly understood by those skilled in the art to which the present disclosure pertains from such description and explanation.

## Claims

1. A thin film transistor comprising:
a gate electrode (150);
an active layer (130) at least partially overlapping the gate electrode (150);
a source electrode (161) on the active layer (130); and
a drain electrode (162),
wherein the active layer (130) includes:
a first channel part (CN1, CN) between the source electrode (161) and the gate electrode (150); and
a connection part (130c, 130d) connected to the first channel part (CN1, CN) and/or exposed by the source electrode (161),
wherein the connection part (130c, 130d) is a conductorized region.

2. The thin film transistor of claim 1, wherein the drain electrode (162) is provided on the active layer (130), the active layer (130) includes a second channel part (CN2) between the drain electrode and the gate electrode and the connection part (130c) is connecting the first channel part (CN1) and the second channel part (CN2).

3. The thin film transistor of claim 1 or 2, wherein the connection part (130c, 130d) is doped with a dopant and a dopant concentration of the connection part (130c, 130d) is higher than a dopant concentration of the first channel part (CN1, CN) and/or a dopant concentration of the second channel part (CN2).

4. The thin film transistor according to any one of the preceding claims, wherein the active layer (130c) further includes:
a first contact part (130a) contacting the source electrode (161), the first channel part (CN1, CN) being between the connection part (130c) and the first contact part (130a), and/or
a second contact part (130b) contacting the drain electrode (162), the second channel part (CN2) being between the connection part (130c) and the second contact part (130b).

5. The thin film transistor according to any one of the preceding claims, wherein the connection part (130c, 130d) overlaps the gate electrode (150); and/or
wherein at least a portion of the connection part (130c, 130d) is exposed by the gate electrode (150).

6. The thin film transistor according to any one of the preceding claims in combination with claim 2, wherein the gate electrode (150) comprises:
a first gate electrode (151) overlapping the first channel part (CN1) and the source electrode (161); and
a second gate electrode (152) overlapping the second channel part (CN2) and the drain electrode (162),
wherein at least a portion of the connection part (130c) is exposed by the gate electrode (150).

7. The thin film transistor according to any one of the preceding claims, further comprising:
an interlayer insulating layer (170) on the active layer (130),
wherein the source electrode (161) and/or the drain electrode (162) are disposed on the interlayer insulating layer (170) and connected to the active layer (130) through a contact hole (CH1, CH2) in the interlayer insulating layer (170).

8. The thin film transistor of claim 7, wherein the interlayer insulating layer (170) is on the connection part (130c), or wherein at least a portion of the connection part (130c) is exposed by the interlayer insulating layer (170).

9. The thin film transistor according to any one of the preceding claims, further comprising:
a capping layer (145) in contact with the connection part (130c), the capping layer (145) having reducing property.

10. The thin film transistor of claim 9, wherein the capping layer (145) includes at least one of titanium, molybdenum, aluminum, indium, and zinc.

11. The thin film transistor according to claim 1, further comprising:
a gate insulating layer (140) covering the gate electrode (150), the gate insulating layer (140) being disposed between the gate electrode (150) and the active layer (130),
wherein a first end of the connection part (130d) that is connected to the first channel part (CN) has a first height that is higher than a second end of the connection part (130d) opposite thereto.

12. The display apparatus according to any one of the preceding claims, wherein the active layer (130) comprises an oxide semiconductor layer.

13. A display apparatus comprising:
a substrate (110);
a thin film transistor according to any one of the preceding claims; and
a light-emitting element (710) configured to emit light, the light-emitting element (170) being connected to one of the source electrode (161) or the drain electrode (162) of the thin film transistor,
wherein the connection part (130c, 130d) of the active layer (130) is exposed by at least one of the source electrode (161) and the drain electrode (162).

14. A manufacturing method of a thin film transistor comprising:
forming a gate electrode (150) on a substrate (110);
forming an active layer (130) on the gate electrode (150), the active layer (130) at least partially overlapping the gate electrode (150);
forming a source electrode (161) on the active layer (130), and
selectively conductorizing a region of the active layer (130) using the source electrode (161)as mask.

15. The manufacturing method of claim 13, wherein a region of the active layer (130) that is overlapping the source electrode (161) is not conductorized during the selective conductorizing and is a first channel part (CN, CN1) connected to the conductorized region; and/or
wherein selectively conductorizing a region of the active layer (130) comprises a dopant doping of the active layer (130).
